# FASCICULE DE BREVET EUROPEEN

(11) **EP 2 786 490 B1**
(45) Date de publication et mention de la délivrance du brevet: **29.05.2019**
(21) Numéro de dépôt: 12798678.4
(22) Date de dépôt: 30.11.2012
(51) Int. Cl.: H03K 17/955

(54) **DISPOSITIF DE DECLENCHEMENT D'UNE ACTION SUR UN OUVRANT DE VEHICULE AUTOMOBILE**
VORRICHTUNG ZUR AUSLÖSUNG EINER HANDLUNG AUF EINER ÖFFNUNGSPLATTE EINES KRAFTFAHRZEUGS
DEVICE FOR TRIGGERING AN ACTION ON AN OPENING PANEL OF A MOTOR VEHICLE

(30) Priorité: 02.12.2011 FR 1103686
(43) Date de publication de la demande: 08.10.2014
(73) Titulaire: Valeo Comfort and Driving Assistance, 94046 Créteil Cedex (FR)
(72) Inventeur: MENARD, Eric, F-94046 Créteil Cedex (FR); MUSAT, Ciprian, F-94046 Créteil Cedex (FR)
(74) Mandataire: Pothmann, Karsten
(86) Numéro de dépôt international: PCT/EP2012/074045
(87) Numéro de publication internationale: WO 2013/079641

(56) Documents cités:
- WO-A1-03/095776
- WO-A1-2010/103084
- DE-A1-102004 045 152
- DE-A1-102004 046 903
- US-A1- 2006 186 992
- US-A1- 2011 181 387
- US-B1- 7 576 631

## Description

La présente invention concerne un dispositif de déclenchement d'une action sur un ouvrant de véhicule automobile. Elle s'applique notamment au domaine du verrouillage et déverrouillage de l'ouvrant d'une porte de véhicule. L'invention trouve une application particulièrement intéressante dans le domaine automobile.

Il est connu d'utiliser un dispositif de déclenchement du verrouillage et déverrouillage d'une porte de véhicule automobile comprenant un capteur capacitif pour détecter une main ou un doigt d'un l'utilisateur du véhicule. Comme le corps humain est constitué de deux tiers d'eau, l'approche du doigt ou de la main de l'utilisateur vers le capteur capacitif fait varier sa capacité. Le capteur capacitif est relié à une unité de gestion qui déclenche le verrouillage ou le déverrouillage de la porte en fonction de l'information délivrée par le capteur capacitif, c'est-à-dire en fonction de la variation de capacité de ce dernier.

Un inconvénient de ce type de dispositif réside en ce que la projection d'une masse d'eau sur la porte, par exemple lors d'une averse de pluie ou d'un lavage du véhicule, peut être interprétée par le capteur capacitif comme une action de l'utilisateur et déclenche le verrouillage ou le déverrouillage de l'ouvrant de manière intempestive. Ceci s'explique par la ressemblance des effets électriques induits.

Le document WO 03/095776 divulgue un dispositif de déclenchement d'une action sur un ouvrant de véhicule automobile par approche d'une main d'un utilisateur. Le dispositif divulgué comprend un capteur capacitif comportant trois électrodes formant un motif de détection. Ce dispositif comprend également une unité de traitement reliée aux électrodes et adaptée pour détecter une variation de capacité simultanément sur deux des trois électrodes, et simultanément à cette variation de capacité, adaptée pour détecter que la capacité d'une des trois électrodes reste fixe.

Le dispositif de l'invention a donc plus particulièrement pour but de remédier aux inconvénients de l'état de la technique susmentionné. Dans ce contexte, l'invention vise à proposer un dispositif de déclenchement d'une action sur un ouvrant de véhicule automobile permettant de s'assurer que l'action réalisée est effectuée par une main ou au moins un doigt d'un utilisateur.

A cette fin, l'invention porte sur un dispositif de déclenchement d'une action sur un ouvrant de véhicule automobile selon les revendications 1 à 4.

On entend par approcher le fait d'être à une faible distance du motif de détection ou d'effleurer ledit motif.

Le dispositif de déclenchement d'une action sur un ouvrant de véhicule automobile permet de s'assurer que l'utilisateur souhaite effectuer une action pour verrouiller ou déverrouiller les portes d'un véhicule avant d'effectuer ladite action.

Comme la main de l'utilisateur ne recouvre qu'une partie de la surface du motif, la main ne peut venir au contact que d'un nombre limité d'électrodes, par exemple deux sur trois. Dans ce cas, l'unité de traitement détecte que la capacité de deux des trois électrodes varie et que la capacité d'une des trois électrodes ne varie pas. Le fait que la capacité d'une des trois électrodes ne varie pas permet d'assurer avec certitude que le verrouillage ou le déverrouillage est réellement souhaité par l'utilisateur.

A contrario, comme la main de l'utilisateur ne recouvre qu'une partie du motif, si une variation simultanée de la capacité des trois électrodes est détectée par l'unité de traitement, alors le dispositif en déduit que ce n'est pas une action de l'utilisateur. Ces variations peuvent être dues simplement à une averse de pluie ou un jet d'eau de lavage. Dans ce cas, aucune action de verrouillage ou déverrouillage n'est effectuée.

En d'autres termes, il est possible de distinguer la projection d'une masse d'eau sur le dispositif de l'approche d'une main de l'utilisateur en direction du dispositif de déclenchement d'une action sur un ouvrant de véhicule automobile.

Le dispositif de déclenchement d'une action sur un ouvrant de véhicule automobile selon l'invention peut également présenter une ou plusieurs des caractéristiques ci-dessous.

Dans un mode de réalisation, les au moins trois électrodes de détection sont espacées les unes des autres. Un tel espacement permet de s'assurer que la capacité d'une électrode n'influe pas sur la capacité d'une électrode voisine.

Dans un mode de réalisation, les au moins trois électrodes de détection sont irrégulièrement espacées de sorte que la densité des électrodes soit plus importante en une région déterminée.

Dans un mode de réalisation, deux électrodes sont espacées d'une distance maximale de sorte qu'une main s'approchant du motif de détection recouvre simultanément lesdites deux électrodes.

Dans un mode de réalisation, le capteur capacitif est un capteur tactile.

Dans un mode de réalisation, l'action de déclenchement sur l'ouvrant est une action de verrouillage ou de déverrouillage dudit ouvrant.

Dans un mode de réalisation, le dispositif de déclenchement d'une action sur un ouvrant de véhicule automobile est adapté pour être positionné sur un levier de préhension de porte de véhicule automobile.

L'invention concerne également un levier de préhension de porte de véhicule automobile comportant un dispositif de déclenchement d'une action sur un ouvrant de véhicule automobile selon la revendication 5.

L'invention a également pour objet une utilisation du dispositif de déclenchement selon la revendication 6.

D'autres caractéristiques et avantages de l'invention ressortiront clairement de la description qui en est donnée ci-après, en référence aux figures annexées ci-jointes, parmi lesquelles :
- la figure 1 illustre un premier mode de réalisation d'un dispositif de déclenchement d'une action sur un ouvrant de véhicule automobile,
- la figure 2 illustre un deuxième mode de réalisation d'un dispositif de déclenchement d'une action sur un ouvrant de véhicule automobile,
- la figure 3 représente une réalisation d'un levier de préhension de porte de véhicule automobile,
- la figure 4 illustre les étapes d'un procédé de déclenchement d'une action sur un ouvrant de véhicule automobile.

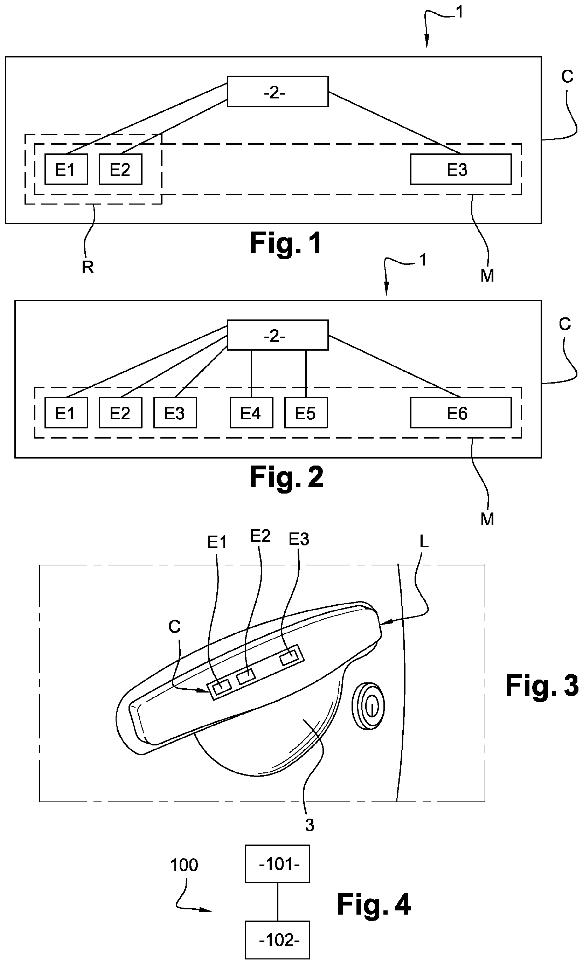

La figure 1 illustre un dispositif 1 de déclenchement d'une action sur un ouvrant de véhicule automobile. Le dispositif 1 comporte un capteur capacitif C de détection d'une variation de capacité comportant trois électrodes E1, E2, E3.

L'association de l'électrode E1, de l'électrode E2 et de l'électrode E3 forme un motif de détection M.

Le dispositif de détection 1 comporte également une unité de traitement 2 reliée au capteur capacitif C pour traiter des signaux de sortie du capteur capacitif C. Chaque signal de sortie que reçoit l'unité de traitement 2 est représentatif de la capacité d'une des trois électrodes E1, E2, E3.

Il convient de noter que le positionnement des électrodes E1, E2, E3 est défini de sorte qu'au moins une des électrodes E1, E2, E3 ne soit pas recouverte par une main s'approchant du motif de détection M. En d'autres termes, selon cette configuration, une main s'approchant du motif de détection M ne peut pas recouvrir la totalité des surfaces des trois électrodes E1, E2, E3. Cela signifie que lorsqu'une main s'approche du motif de détection M, la capacité d'au moins une des trois électrodes ne varie pas (i.e. la capacité d'au moins une des trois électrodes reste fixe) tandis que la capacité des deux autres électrodes varie.

Dans l'exemple illustré sur la figure 1, les trois électrodes E1, E2, E3 sont irrégulièrement espacées les unes des autres. La densité des électrodes E1, E2 est plus importante dans la région déterminée R située du côté droit du motif de détection M. Dans cet exemple, les électrodes E1 et E2 sont espacées d'une distance maximale de sorte qu'une main s'approchant du motif de détection M recouvre simultanément les deux électrodes E1 et E2. A titre d'exemple, la distance maximale est de....

La région déterminée R correspond à une région plus accessible par un utilisateur, autrement dit la région R où l'utilisateur va naturellement positionner sa main lorsqu'il souhaite ouvrir une porte sur laquelle est positionné le dispositif de déclenchement 1.

En outre, l'unité de traitement 2 est adaptée pour effectuer une action de déclenchement sur l'ouvrant du véhicule automobile lorsqu'une main s'approche du motif de détection M.

Plus particulièrement, l'unité de traitement 2 est adaptée pour détecter une variation de capacité d'au moins une des électrodes E1, E2, E3, par exemple E1 et E2. De surcroît, l'unité de traitement 2 est adaptée pour déclencher une action sur l'ouvrant du véhicule automobile si une variation de capacité est détectée sur au moins une des électrodes, E1 et E2 dans notre exemple, et si simultanément à cette variation de capacité, la capacité d'une au moins des électrodes reste fixe, E3 dans notre exemple.

L'action de déclenchement est une action de déverrouillage ou de verrouillage de l'ouvrant du véhicule automobile. L'action de déverrouillage ou de verrouillage peut être effectuée sur seulement une porte ou sur l'ensemble des portes du véhicule.

Dans une réalisation le capteur capacitif C est un capteur tactile.

Dans une réalisation particulière, le dispositif est adapté pour être positionné à l'intérieur d'un levier de préhension (i.e. une poignée) de porte de véhicule automobile.

Comme illustré sur la figure 2, il est entendu que le capteur capacitif C peut comporter plus de trois électrodes, par exemple six électrodes E1, E2, E3, E4, E5, E6. Dans ce cas, une main peut par exemple faire varier simultanément la capacité des électrodes E1, E2, E3 ou des électrodes E4, E5 ou encore des électrodes E5 et E6.

Dans un exemple, l'unité de traitement 2 est un produit programme d'ordinateur qui comporte comme paramètres d'entrée les signaux de sortie du capteur capacitif C.

Dans un mode de réalisation, un dispositif de déclenchement 1 d'une action sur un ouvrant de véhicule automobile est intégré dans un levier L de préhension de porte de véhicule automobile. Dans l'exemple illustré sur la figure 3, le levier de préhension L présente un évidement intérieur 3 dans lequel est intégré le capteur capacitif C. Dans l'exemple illustré sur la figure 3, les électrodes E1, E2, E3 sont irrégulièrement espacées sur la surface de l'évidement 3 levier de préhension L. Les électrodes E1, E2, E3 sont également agencées linéairement sur la surface de l'évidement 3. Par cet agencement spécifique, une main s'approchant du motif de détection ne peut pas recouvrir la totalité des électrodes E1, E2, E3 pour déclencher une action de verrouillage ou de déverrouillage sur l'ouvrant du véhicule automobile.

La figure 4 illustre un procédé 100 de déclenchement d'une action sur un ouvrant de véhicule automobile mis en oeuvre par le dispositif 1. Le procédé 100 comporte les étapes de :
- détection 101 de variation de capacité d'au moins une des électrodes, la détection étant réalisée par l'unité de traitement 2 du capteur capacitif C,
- déclenchement 102 d'une action sur un ouvrant de véhicule automobile par l'unité de traitement 2, le déclenchement 102 est réalisé si une variation de capacité est détectée sur au moins une des électrodes et si simultanément à cette variation de capacité, la capacité d'une au moins des électrodes reste fixe.

## Revendications

1. Dispositif de déclenchement (1) d'une action sur un ouvrant de véhicule automobile par approche d'une main d'un utilisateur, ledit dispositif étant intégré dans le levier de préhension (L) de l'ouvrant, ledit dispositif comportant:
- un capteur capacitif (C) de détection d'une variation de capacité comportant au moins trois électrodes (E1, E2, E3), lesdites au moins trois électrodes (E1, E2, E3) formant un motif de détection (M),
- une unité de traitement (2) reliée audit capteur capacitif (C) pour traiter des signaux de sortie dudit capteur capacitif (C), lesdits signaux de sortie étant représentatifs de la capacité de chacune desdites au moins trois électrodes (E1, E2, E3),
le positionnement desdites électrodes (E1, E2, E3) étant défini de sorte que lors de l'approche du motif de détection (M) par la main de l'utilisateur, l'unité de traitement est adaptée pour détecter une variation de capacité simultanément sur au moins deux desdites au moins trois électrodes, et simultanément à cette variation de capacité, l'unité de traitement est adaptée pour détecter que la capacité d'une au moins desdites au moins trois électrodes reste fixe, afin de d'effectuer ladite action de déclenchement sur l'ouvrant du véhicule automobile,
**caractérisé en ce que** lesdites au moins trois électrodes sont irrégulièrement espacées les unes des autres, de sorte que la densité des électrodes (E1 E2, E3) soit plus importante en une région déterminée (R), et sont agencées linéairement sur la surface d'un évidement intérieur du levier de préhension.

2. Dispositif (1) selon l'une des revendications précédentes **caractérisé en ce que** deux électrodes (E1, E2) sont espacées d'une distance maximale de sorte qu'une main s'approchant du motif de détection (M) recouvre simultanément lesdites deux électrodes (E1, E2).

3. Dispositif (1) selon l'une des revendications précédentes **caractérisé en ce que** le capteur capacitif (C) est un capteur tactile.

4. Dispositif (1) selon l'une des revendications précédentes **caractérisé en ce que** l'action de déclenchement sur l'ouvrant est une action de verrouillage ou de déverrouillage dudit ouvrant.

5. Levier de préhension (L) de porte de véhicule automobile comportant un dispositif de déclenchement (1) d'une action sur un ouvrant de véhicule automobile selon l'une des revendications précédentes.

6. Utilisation du dispositif de déclenchement (1) selon l'une des revendications précédentes dans un procédé de déclenchement (100) d'une action sur un ouvrant de véhicule automobile mettant en oeuvre le dispositif de déclenchement (1) selon l'une des revendications précédentes, ledit procédé (100) comportant les étapes de:
- détection (101) des variations de capacité desdites au moins trois électrodes, ladite détection étant réalisée par l'unité de traitement (2) du capteur capacitif (C),
- déclenchement (102) d'une action sur un ouvrant de véhicule automobile par l'unité de traitement (2), ledit déclenchement étant réalisé si une variation de capacité est détectée simultanément sur au moins deux desdites au moins trois électrodes et si simultanément à cette variation de capacité, la capacité d'une au moins desdites au moins trois électrodes reste fixe.

## Patentansprüche

1. Vorrichtung zum Auslösen (1) einer Handlung an einem Öffnungselement eines Kraftfahrzeugs durch Annähern einer Hand eines Benutzers, wobei die Vorrichtung in einen Griffhebel (L) des Öffnungselements integriert ist, wobei die Vorrichtung umfasst:
- einen kapazitiven Sensor (C) zur Detektion einer Kapazitätsänderung, der mindestens drei Elektroden (E1, E2, E3) umfasst, wobei die mindestens drei Elektroden (E1, E2, E3) ein Detektionsmuster (M) bilden,
- eine Verarbeitungseinheit (2), die mit dem kapazitiven Sensor (C) verbunden ist, um Ausgangssignale des kapazitiven Sensors (C) zu verarbeiten, wobei die Ausgangssignale für die Kapazität jeder der mindestens drei Elektroden (E1, E2, E3) repräsentativ sind,
wobei die Positionierung der Elektroden (E1, E2, E3) so definiert ist, dass die Verarbeitungseinheit bei der Annäherung an das Detektionsmuster (M) mit der Hand des Benutzers dazu eingerichtet ist, eine Kapazitätsänderung gleichzeitig an mindestens zwei der mindestens drei Dioden zu detektieren, und die Verarbeitungseinheit gleichzeitig zu dieser Kapazitätsänderung dazu eingerichtet ist zu detektieren, dass die Kapazität von mindestens einer der mindestens drei Dioden unverändert bleibt, um die Auslösehandlung am Öffnungselement des Kraftfahrzeugs vorzunehmen,
**dadurch gekennzeichnet, dass** die mindestens drei Dioden unregelmäßig voneinander beabstandet sind, so dass die Dichte der Elektroden (E1 E2, E3) in einer bestimmten Region (R) höher ist, und linear an der Oberfläche einer inneren Ausnehmung des Griffhebels angeordnet sind.

2. Vorrichtung (1) nach einem der vorhergehenden Ansprüche, **dadurch gekennzeichnet, dass** zwei Elektroden (E1, E2) um eine maximale Distanz beabstandet sind, so dass eine Hand, die sich dem Detektionsmuster(M) nähert, die beiden Elektroden (E1, E2) gleichzeitig bedeckt.

3. Vorrichtung (1) nach einem der vorhergehenden Ansprüche, **dadurch gekennzeichnet, dass** der kapazitive Sensor (C) ein berührungsempfindlicher Sensor ist.

4. Vorrichtung (1) nach einem der vorhergehenden Ansprüche, **dadurch gekennzeichnet, dass** die Auslösehandlung am Öffnungselement eine Handlung zur Verriegelung oder Entriegelung des Öffnungselements ist.

5. Griffhebel (L) einer Kraftfahrzeugtür mit einer Vorrichtung (1) zum Auslösen einer Handlung an einem Öffnungselement eines Kraftfahrzeugs nach einem der vorhergehenden Ansprüche.

6. Verwendung der Auslösevorrichtung (1) nach einem der vorhergehenden Ansprüche in einem Verfahren (100) zum Auslösen einer Handlung an einem Öffnungselement eines Kraftfahrzeugs, das die Auslösevorrichtung (1) nach einem der vorhergehenden Ansprüche einsetzt, wobei das Verfahren (100) die folgenden Schritte umfasst:
- Detektion (101) der Kapazitätsänderungen der mindestens drei Elektroden, wobei die Detektion von der Verarbeitungseinheit (2) des kapazitiven Sensors (C) ausgeführt wird,
- Auslösen (102) einer Handlung an einem Öffnungselement eines Kraftfahrzeugs durch die Verarbeitungseinheit (2), wobei das Auslösen ausgeführt wird, wenn eine Kapazitätsänderung gleichzeitig an mindestens zwei der mindestens drei Elektroden detektiert wird und wenn gleichzeitig zu dieser Kapazitätsänderung die Kapazität mindestens einer der mindestens drei Dioden unverändert bleibt.

## Claims

1. Device (1) for triggering an action on an opening panel of a motor vehicle through the approach of a hand of a user, said device being integrated into the gripping lever (L) of the opening panel, said device including:
- a capacitive sensor (C) for detecting a variation in capacitance including at least three electrodes (E1, E2, E3), said at least three electrodes (E1, E2, E3) forming a detection pattern (M),
- a processing unit (2) linked to said capacitive sensor (C) to process the output signals of said capacitive sensor (C), said output signals being representative of the capacitance of each of said at least three electrodes (E1, E2, E3),
- the positioning of said electrodes (E1, E2, E3) being defined in such a way that, when the detection pattern (M) is approached by the hand of the user, the processing unit is adapted to simultaneously detect a variation in capacitance on at least two of said at least three electrodes, and, at the same time as this variation in capacitance, the processing unit is adapted to detect that the capacitance of at least one of said at least three electrodes remains fixed, so as to perform said triggering action on the opening panel of the motor vehicle,
**characterized in that** said at least three electrodes are irregularly spaced apart from one another in such a way that the density of the electrodes (E1, E2, E3) is higher in a determined region (R), and are arranged linearly on the surface of an inner recess of the gripping lever.

2. Device (1) according to one of the preceding claims, **characterized in that** two electrodes (E1, E2) are spaced by a maximum distance in such a way that a hand approaching the detection pattern (M) simultaneously covers said two electrodes (E1, E2).

3. Device (1) according to either of the preceding claims, **characterized in that** the capacitive sensor (C) is a tactile sensor.

4. Device (1) according to one of the preceding claims, **characterized in that** the triggering action on the opening panel is an action of locking or unlocking said opening panel.

5. Gripping lever (L) of a door of a motor vehicle including a device (1) for triggering an action on an opening panel of a motor vehicle according to one of the preceding claims.

6. Use of the triggering device (1) according to one of the preceding claims in a method (100) for triggering an action on an opening panel of a motor vehicle implementing the triggering device (1) according to one of the preceding claims, said method (100) including the steps of:
- detecting (101) the variation in capacitance of said at least three electrodes, said detection being performed by the processing unit (2) of the capacitive sensor (C),
- triggering (102) an action on an opening panel of a motor vehicle by the processing unit (2), said triggering being performed if a variation in capacitance is detected simultaneously on at least two of said at least three electrodes and if, simultaneously with this variation in capacitance, the capacitance of at least one of said at least three electrodes remains fixed.
